# EUROPEAN PATENT SPECIFICATION

(11) **EP 2 003 689 B1**
(45) Date of publication and mention of the grant of the patent: **12.06.2019**
(21) Application number: 07011801.3
(22) Date of filing: 15.06.2007
(51) Int. Cl.: H01L 23/055, H01L 23/045

(54) **Header, especially for electronic packages**
Kopfstück, insbesondere für elektronische Gehäuse
En-tête, en particulier pour des boîtiers électroniques

(43) Date of publication of application: 17.12.2008
(73) Proprietor: Schott AG, 55122 Mainz (DE)
(72) Inventor: Bhosale, Rohit, 84028 Landshut (DE); Hettler, Robert, 84036 Kumhausen (DE); Zetterer, Thomas, 84034 Landshut (DE); Walter, Martin, 84051 Essenbach (DE); Wittmann, Martin, 84098 Hohenthann (DE)
(74) Representative: Sawodny, Michael-Wolfgang

(56) References cited:
- EP-A- 0 684 651
- GB-A- 1 163 785
- JP-A- 2005 217 098
- NL-A- 8 304 036
- US-A- 3 546 363
- US-B1- 6 351 385

## Description

The invention relates to a header, especially for electronic packages, an electronic package with such a header as well as a process for manufacturing an electronic package.

Headers according to the state of the art are known from GB 1,163,785 A, US 6,351,385 B1 and EP 0684651 A2.

The header from GB 1,163,785 A includes a plurality of alternate layers of glass and ceramic material which are fused together and a plurality of lead wires extending through the layers and held in plan by fusing glass in the layers to the wires.

US 6,351,385 B1 describes an integrated circuit heat dissipator comprising a unitary piece of metallic material for disspating thermal energy generated by semiconductor devices encapsulated in a DIP integrated circuit package. The heat dissipater is adapted to accept heat conducting pins of the integrated circuit. Soldering secures the heat dissipator and the integrated circuit heat conducting pins to each other and to the printed circuit board. A bulk mass of heat conducting solder is retained at the connection of the heat dissipator and the heat conducting pins for enhancing the heat sinking of the pins by the heat dissipator.

EP 0684651 A2 shows a photodetector module containing a package (1), a photodiode (3), a preamplifier (4), a bypass capacitor (2), a cap (7) with a lens (6) and a sleeve (8). A parallel plate capacitor (2) is used as the bypass capacitor. The parallel plate capacitor (2) is mounted at the center of the package. The photodiode (3) is stuck on the parallel plate capacitor.

Further headers according to the state of the art are known from the internet side www.us.schott.com of SCHOTT Electronic Packaging, SCHOTT North America Inc. The content of this homepage is enclosed herein in its entirety.

Headers known from this web side can be either for example shelled headers having a hollow head which is filled with glass such as Schott header TO 5 or TO 18 of Schott Electronic Packaging. Alternatively so called stamped headers have been made known having a solid head typically made out of Kovar or a metal alloy for example Alloy 42. The stamped header can have either a raised or a flat head. Headers of this type are for example headers TO 8, TO 38, TO 39, TO 41, TO 46, TO 56 of Schott Electronic Packaging shown on the homepage of SCHOTT North America.

Stamped headers as described above are comprising typically three components. The stamped metal which is also denoted as eyelet, a glass material and at least a pin. These three components are met together in various combinations to create a compression seal for example for a transistor outlet, a so called TO.

The headers normally have a round shape and therefore can be easily interconnected with caps also of round shape in order to provide for electronic packages.

Such electronic packages can also comprise one cap with a plurality of headers. The shelled headers as well as the stamp headers are typically made out of a material having a similar thermal expansion coefficient as the caps as well as the other electronic components which are added for example in a process of optoelectronic device packaging.

The stamped headers normally comprise metals like steel or Kovar.

In the case of stamped headers holes are introduced into the header in a stamping process. After stamping a pin is inserted into that hole and the hole is sealed according to the known glass seal technology with a glass material.

A disadvantage of the stamped headers is the fact that the hole-to-hole dimension is limited. In order to avoid the walls to collapse after stamping, a minimum spacing between adjacent holes is required depending on the thickness of the metal eyelet. This requirement reduces the total number of holes that can be stamped into a metal eyelet.

A further disadvantage of the headers manufactured from a stamped eyelet, is that the glass which is used to seal the pins requires a certain diameter to seal the pin into the metal. This requirement is necessary to guarantee a hermetic bond between the metal, the glass and the pin. Therefore, also the glass with its outside diameter determines the size of the holes that must be stamped into the eyelets and therefore reduces the number of stampable holes in the eyelet. This, on the other hand, limits the number of feedthroughs to be carried in and out for example of an electronic package in which that header is used.

Furthermore, the glass seal around the pin also limits the amount of surface area available for the mounting of electronic devices onto the cover of the header, since the electronic devices normally cannot be mounted directly on glass.

It is therefore an object of the invention to avoid the disadvantages described above.

Especially with the invention a header should be provided which provides for a greater surface area available for the mounting of electronic devices onto the header and therefore for the electronic package. Furthermore the number of feedthroughs through the header should be increased compared to headers according to the state of the art.

These problems are solved according to the invention by a header according to claim 1.

According to the invention a header, is provided with a hollow head filled with a glass material, wherein said glass material accommodates at least a pin and wherein said hollow head comprises at least hollow part and a cover part and wherein the hollow part and the cover part are separate parts. Furthermore the glass material which is filled into the hollow part is according to the invention a glass preform. The glass preform can be manufactured separately. The glass perform can then be inserted into the hollow part having a certain geometry and holes already provided in said preform which can accommodate the pins.

After the glass perform is inserted in the hollow part, the cover part is interconnected to the hollow part. When interconnecting the hollow part to the cover part also at least a pin can be electrically connected to the cover part in one process step. In such a case the pin preferably extends above the cover part. The electrical interconnection of the cover part with the pin can be provided e.g. by welding or by hard soldering.

The cover part of the header according to the invention is of a different material than the hollow part.

The hollow part has the dimensions of an eyelet which is used in the state of the art, e. g. the eyelet of a stamped header. The hollow part is manufactured from a metal preferably a steel, a steel alloy, an iron alloy, a nickel alloy or an iron-nickel alloy. The metal mentioned above allows for hermetic packages for electronic components consisting of a header according to the invention and a cap that houses the actual components. A metal material allows for a hermetic interconnection between the header and the cap for example, when interconnected by resistance welding, laser welding, press fit welding, cold welding, face controlled welding and capacitor discharge welding.

The cover part of the header is according to the invention made of a ceramic material. Onto to cover part of the ceramic material, electronic components for example in electronic packages can be positioned.

There are a variety of possibilities to connect the pins to the outer surface of the ceramic cover part. In a first embodiment, the ceramic has a hole through which the pin, and only the pin, can pass through from the lower part of the cover part to the upper part of the cover part.

Since there is no glass material necessary to surround the pin, the corresponding hole in the ceramic cover part is smaller than in case of a stamped header. This allows for more pins to be accommodated than in the state of the art. In an alternative embodiment, contact pads for the pins can be provided in holes with a diameter much smaller than the pin in the ceramic cover part.

In general, the number of pins in the hole-to-hole positioning on the ceramic is much higher than in case of metal stamping and the hole-to-hole positioning in glass. Furthermore the entire surface of the ceramic can be conveniently prepared to accommodate electronic devices.

By using for example a ceramic material as a material for the cover part no glass material is necessary to surround each of the pins as for example in a stamped header. Therefore the numbers of pins can be increased, whereas the plateau diameter remains constant. This is described in the following:
A stamped header is for example the header TO46 (transistor outlet) disclosed on the home page www.us.schott.com/epackaging/. The stamped header TO46 has a plateau diameter of the cover part of 4.2 mm and comprises in total six pins. An inventive header having a plateau diameter of the cover part of 4.2 mm comprises about eight pins. By the inventive concept the number of pins could be increased to eight pins while the plateau diameter remained at a value of 4.2 mm. The distance between adjacent pins was in the state of the art about 1,2 mm, whereas in the inventive header the distance between adjacent pins is about 0,7 mm.

The header comprising a hollow part with a glass material and a cover part wherein the cover part and the hollow part are separate parts can be used in an electronic package, for example for an optoelectronic device. Due to the higher number of pins in the inventive header over the state of the art the used area of the cover part for input/output devices could be increased significantly. According to the state of the art only about 60 % of the surface of the cover part could be used for output/input devices, whereas according to the invention about 90 % of the surface could be used.

The electronic package comprises a cap which is interconnected to the header. The cap comprises electronic components which can be situated within the cap and on the cover part of the header. The cap and the header are interconnected in such a way that a hermetically sealed housing results. In a preferred embodiment, the cover parts, comprising a ceramic could be patterned with a printing layout. Onto the printing layout the electronic components could be mounted. The pattern or the printing layout could consist of conductive pastes or metals. The step of patterning for example a circuit on top of the ceramic cover part could be made either before sealing the header to the cup of the electronic package or after sealing the cup to the electronic package. Making the pattern after the sealing process has the advantage that the header could be used for different designs and layouts on the top of the cover part for different usage.

As a material for patterning for example a circuit pattern before sealing the cap to the header can comprise Tungsten or TiW. After sealing the header to the electronic package a thick or thin film technology can be used for patterning the top of the ceramic part. Possible materials for the thick film technology are pastes of Ag, AgPt or Au. According to the thin film technology for example thin TiW-films could be provided for patterning the top of the cover part. As mentioned above patterning after sealing leads to the possibility of universal designs with custom screen printing designs according to customer requirements.

As already pointed out above the inventive header has the advantage that a higher number of pins than in stamped headers according to the state of the art can be realized. Furthermore a larger mountable surface area on the top of the cover part of the header is provided. Since it is possible to pattern the ceramic cover part with a wiring, the bond wires can be shortened with respect to the prior art and therefore the inductivity which is relevant for high frequency applications could be reduced.

Preferably the electronic package is used in an optoelectronic device.

The drawings show:
Fig. 1 sectional view of a header according to the invention
Fig. 2a-2b three-dimensional view of a header according to the invention
Fig. 3a and 3d sectional view of different embodiments of headers according to the invention
Fig. 3b-3C.2 and 3e-3f.2 sectional view of different examples of headers not forming part of the invention but useful for understanding it
Fig. 4a-4b sectional views of headers according to the state of the art
Fig. 5 sectional view of a header according to the state of the art sealed with a cap in detail

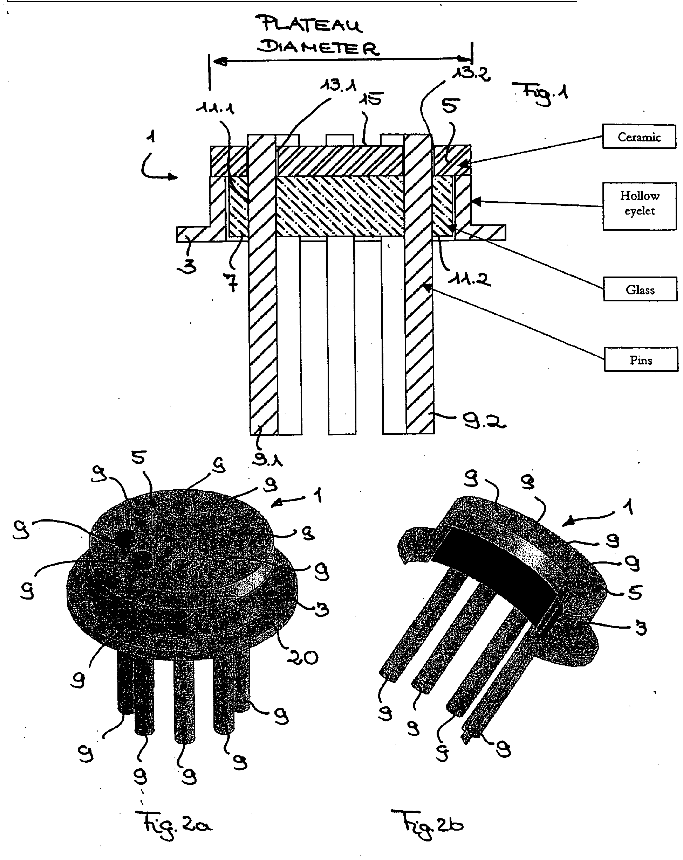

In Fig. 1 is shown a header according to the invention. The header according to the invention comprises a hollow head 1 comprising a hollow part 3 and a cover part 5. The cover part 5 is made of a ceramic material. The hollow part 3 is made of a metal, preferably steel, steel alloy, iron alloy, nickel-allow or an iron-nickel alloy.

The hollow part is covered by the cover part which is of a different material than the hollow part.

The hollow part furthermore accommodates a glass part 7. The glass part 7 which fills the hollow part accommodates pins 9.1, 9.2 which are fed through to the glass part 7. The glass part 7 is a preform with holes 11:1, 11.2 through which the pins 9.1, 9.2 are fed.

The cover part made of a ceramic material in the embodiment shown also comprises hollows 13.1, 13.2 through which the pins 9.1, 9.2 are fed into the upper side 15 of the cover part made of a ceramic material.

The whole diameter is substantially the diameter of the pins fed through the glass preform and the cover part.

The cover part 5 covers the hollow part 3 of the inventive header.

The glass preform consists preferably of a glass material which has substantially the same coefficient of expansion as the metal of the surrounding hollow part and the ceramic material of the cover part.

Preferably the glass preform consists of a glass material described in the homepage of SCHOTT North America, SCHOTT Electronic Packaging in the material data table. Such a glass material can be glass number 8250, glass material 8350, glass material 8421, glass material 8422, glass material 8537, glass material 8629 or glass material 8630. The expansion coefficient of these materials varies between 9,6 x 10⁻⁶ 1/K to 5,0 x 10⁻⁶ 1/K.

The expansion coefficient is given with regard to a temperature rate from 20° C to 300° C according DIN 52328.

The ceramic material from which the cover part is made is preferably aluminiumnitrid (AIN) aluminiumoxid (Al₂ O₃) or berylliumoxid (BeO) with corresponding holes 13.1, 13.2 for the pins 9.1, 9.2 going through it. A cover part comprising aluminiumnitrid (AIN) or aluminiumoxid has the advantage of a very good thermal conductivity.

The pin preferably is made of a material with a high electric conductivity, and the coefficient of thermal expansion is matched to the used glass in order to avoid cracking. Typical materials are Kovar Alloy (per ASTM-F15), Alloy 42 (per ASTM F-30).

Preferably the hollow part 3 and the cover part 5 is assembled with the cover part 5 on the bottom and the rest of the material such as the hollow part 3 resting on it After the hollow part 3, the cover part 5, the glass perform 7 and pins 9.1, 9.2 are assembled together, in the parts are sealed at a glass sealing temperature of the glass preform. The seal between the glass and ceramic holds the assembly together and the seal between the glass material and the pins provides the hermeticity of the feedthrough. Furthermore when sealing the parts together at a high glass sealing temperature it is possible to solder the pins e.g. to the metal of the hollow part providing for a signal case or to solder the pins to respective input/output devices (not shown) provided on the cover part of the header. It is also possible to connect one or more of the pins to a signal ground.

Fig. 2a and 2b are three dimensional views of a header according to the invention.

Fig. 2a is a top view showing the cover part 5 as well as the hollow part 3 with an outer flange 20 as well as eight pins 9 which are fed through the cover part. As is apparent from the embodiment shown in Fig.2a eight pins are provided, whereas a header according to the state of the art only comprises six pins within the same diameter of the plateau diameter D of the cover part 5.

Same parts as is Fig. 1 are designated with the same reference numbers.

Fig. 2b is a sectional three-dimensional view of a part shown in fig. 2a. As is shown in fig. 2b the hollow head 1 consists of two separate parts, the cover part 5 and the hollow part 3.

The hollow part 3 comprises the glass perform 7. The cover part is made of a ceramic material.

Also same reference numbers as in the figures before denote similar parts.

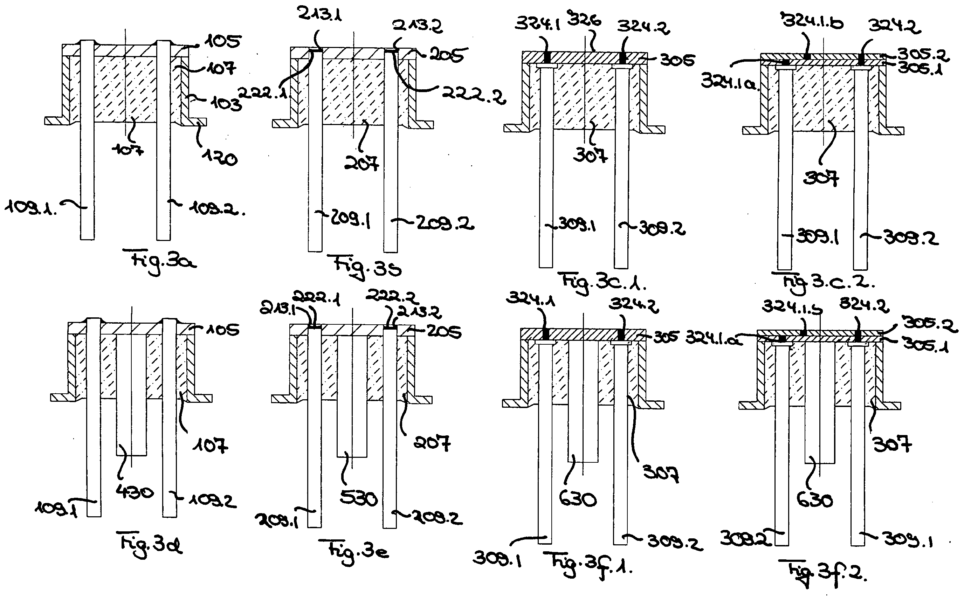

Fig. 3a shows a sectional view of a first embodiment of the invention, in which the glass pins 109.1, 109.2 are fed through the glass preform 107 as well as through the cover part 105 comprising a ceramic. The cover part 105 covers the hollow part 103 preferably made of a metal with a flange 120.

Fig. 3a shows a sectional view of a first embodiment of the invention, in which of the eight pins, the two pins 109.1, 109.2 shown are fed through the glass perform 107 as well as through the cover part 105 comprising a ceramic. The cover part 105 covers the hollow part 103 preferably made of a metal with a flange 120. In case of the embodiment of figure 3a the pins 109.1, 109.2 fed through the cover part could be connected e.g. to input/output devices provided on the cover part by soldering. The soldering could be performed together with providing a seal of the glass material, the ceramic material and the pins as described above at a high glass sealing temperature.

Fig. 3b shows an example not forming part of the invention but useful for understanding the invention with the pins 209.1, 209.2 fed through the glass preform 207 but not fed totally through the cover part 205. The two holes 213.1, 213.2 in the cover part 205 through which the pins 209.1, 209.2 are partially fed through have the same dimension respectively the same diameter as the pins 209.1, 209.2. The upper end of the pins 209.1, 209.2 is covered e.g. by a conductive metal or a conductive paste 222.1, 222.2. The upper end of the pins could be connected via the conductive paste to an electric device provided on the cover part of the header e.g. by soldering as described above.

Fig. 3.c.1 shows a totally different example not forming part of the invention but useful for understanding it, in which the pins 309.1, 309.2 are only fed through the glass perform 307 inserted into the hollow part and not fed through the cover part which covers the hollow part. The pins 309.1, 309.2 are fixed to the cover part and the cover part comprises in the area in which the pins are fixed to the cover part 305 in an area, in which holes with a smaller diameter than the pins are provided. The two holes 324.1, 324.2 with a smaller diameter than the pins 309.1, 309.2 are filled with a conductive material, for example a paste, in order to provide a conductive connection between the top side 326 of the cover part 305 and the pin 309.1, 309.2. Electricity of an electronic device which is packed onto the top of the cover part is then transported via the conductive material towards the pin. In the example shown in Fig. 3.c.1 the ceramic material consists of one layer with a hole 324.1, 324.2 through the whole ceramic material at the position where the pin is situated. In a even more flexible example, not forming part of the invention but useful for understanding it, shown in Fig.3.c.2 the ceramic material consists of a plurality of layers e.g. as shown two layers 305.1, 305.2. This has the advantage that the e.g. the hole 324.1 filled with conductive material can consist of two parts a first part 324.1.a and a second part 324.1.b. The first part 324.1.a is conductively connected to the second part 324.2.b but as shown displaced to the first part 324.1.a. This provides for the advantage that a electronic device e.g. an input/output device which is mounted on the cover part of the header can be locted at a different position than the pin to which the device is connected. This allows for an arbitrary distribution of electronic devices on the surface of the cover part adopted to the needs of the customer.

Figures 3d, 3e, 3f.1 and 3f.2 show in principle the same headers as in fig. 3a, 3b, 3c.1 and 3c.2 with the difference that the headers shown in fig. 3d, 3e and 3f comprises the eight conductive pins as well as a thermal pin 430, 530, 630 which is fed through the glass perform 407, 507, 607 but not fed through the cover part. The thermal pin 430, 530, 630 provides for a good thermal conductivity through the glass preform 407, 507 and 607. The thermal pin 430, 530, 630 is thermally connected to the ceramic material of the cover part. Preferably the thermal pin is made of the following materials:
AlN,
CuW
Kovar or
SiC.

Most preferably the thermal pin is of the same material as the cover part itself. By the thermal pin heat can be removed.

Apart from the difference that the embodiments according to fig. 3d - 3f.2 comprise a thermal pins, fig. 3d coincidence with fig. 3a and fig. 3e coincidence with fig. 3b and fig. 3f.1 coincidence with fig. 3c.1 and fig 3f.2 coincidence with fig.3c.2.

The same parts as in these figures are denoted with the same reference numbers.

The most preferred headers are the headers of figures 3c.1, 3c.2, 3f.1 and 3f.2. This is due to the fact that the size of the pin does not determine the size of the connection to the electronic device mounted on the cover part. For example can the diameter of the hole filled with the conductive material be in the region of 200 µm, whereas the diameter of the electrically conductive pin is about 400 µm. This means that the diameter of the hole filled with conductive material is roughly half of the diameter of the pin. By this measure electrical components mounted on the cover part could be packed more densly.

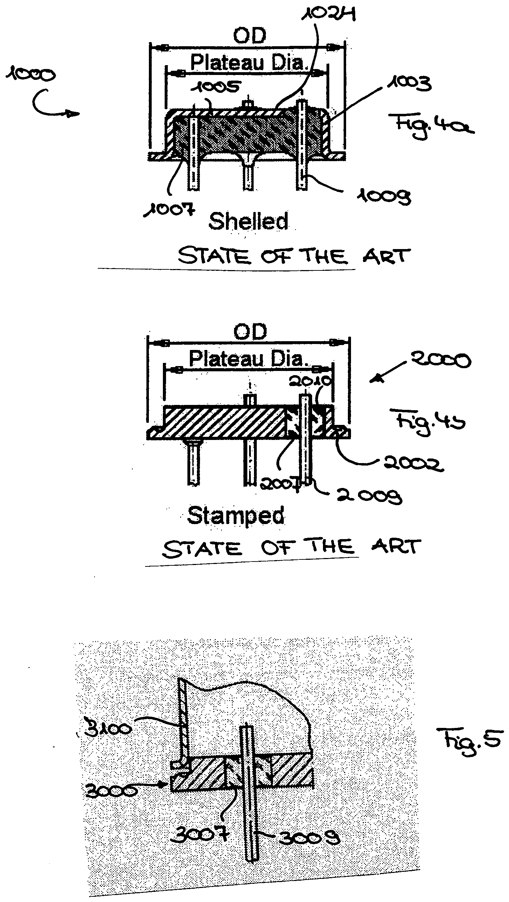

In Fig. 4a and 4b a are shown headers according to the state of the art. Fig. 4a shows a so called shelled header 1000. The shelled header 1000 comprises a hollow head part which is a single metal part comprising the hollow body 1003 as well as the cover body 1005. Apart from the fact that the shelled header according to the state of the art comprises only one part, the header does not comprise a glass preform but is totally filled with the glass material 1007. Furthermore the glass material also surrounds the pin 1009 which is fed through the top 1024 of the header.

As pointed out before, the pin 1009 which is fed through the cover in the embodiment according to figure 4a is surrounded with the glass material. In the area in which the glass material surrounds the pin as described before it is not possible to mount any electronic device onto the top 1024 of the header.

In Fig. 4b a stamped header 2000 according to the state of this art is shown. The stamped header has a solid body 2002 typically made out of Kovar (ASTM F 15) or alloy 42 (ASTM F 30). The stamped header has a head with a stamped hole 2010 through which the pin 2009 is fed. Within the hole 2010 the pin 2009 is surrounded by a glass material 2007 giving raise for the same disadvantages as described with the shelled header before.

In Fig. 5 it is shown how a header becomes part of a hermetic package for an electronic component. The electronic package comprises the header which can be a conventional header according to figure 4a and 4b or a header according to the invention shown in fig. 1 to fig. 3f.2.

The header is the so called base plate 3000 of the electronic package. The components (not shown) are mounted on to the base plate 3000. Furthermore the electronic package comprises a so called cap 3100 that houses the electronic components. Cap 3100 and header 3000 are hermetically interconnected and furthermore their interconnection is also vacuum tight. In the header in the region, in which the header 3000 is interconnected to the cap 3100 comprises a metal. The cap can then be interconnected with the header by various processes such as
- resistance welding
- laser welding
- press-fit welding
- cold welding
- soldering

The most common technique to interconnect the cap to the header is the resistance welding technique which can be used either as a phase controlled welding or a capacitor discharge welding.

Therefore the header according to the invention provides a larger mountable surface area for electronic components when used in an electronic package than headers of the state of the art having about the same plateau diameter of the cover part. Furthermore since the plateau diameter is not changed all processing steps such as cap welding for manufacturing the electronic package remain whereas a larger amount of electronic devices can be mounted on the cover parts. Furthermore some embodiments allow for a free distribution of the position of the electronic components or devices on the cover part independent from the position of the electrically conductive pin the electronic components are associated to.

## Claims

1. Header for electronic packages comprising:
- a hollow head (1) filled with
- a glass material, wherein said glass material accommodates at least a pin (9.1, 9.2, 9) and;
- wherein said hollow head (1) is composed at least of a hollow part (3) and a cover part (5); and
- wherein said hollow part (3) and said cover part (5) are separate parts, and
- wherein the hollow part (3) surrounds the glass material
- wherein the cover part (5) covers the hollow part (3)
- wherein the hollow part (3) is made from a metal,
- wherein the cover part (5) is made from a ceramic and comprises holes (13.1, 13.2) through which said at least one pin (9.1, 9.2) is fed into the upper side (15) of the cover part (5), **characterized in that**
- said glass material is a glass preform (7) that is inserted into said hollow part (3) and **in that** said glass preform (7) comprises holes (11.1, 11.2) through which said at least one pin (9.1, 9.2, 9) is fed so that no glass material surrounds said at least one pin (9.1, 9.2) in said holes (13.1, 13.2) of the cover part (5).

2. Header according to claim 1 , wherein said hollow part has a shape of an eyelet.

3. Header according to one of the claims 1 to 2, wherein said metal is one of the following metals or a combination thereof:
- a steel
- a steel alloy
- a iron alloy
- a nickel alloy
- a iron-nickel alloy

4. Header according to one of the claims 1 to 3, wherein said ceramic material is one of the following materials or a combination thereof:
AlN
Al₂O₃
BeO

5. Header according to one of the claims 1 to 4, wherein said header comprises a thermal pin (430, 530, 630) comprising one of the following materials or a combination thereof:
AIN
CuW
Kovar
SiC.

6. Header according to one of the claims 1 to 5, wherein the glass material (7) consists of a glass material which has substantially the same coefficient of thermal expansion as the metal of the surrounding hollow part and the ceramic of the cover part.

7. Header according to one of the claims 1 to 6, wherein said pin (9.1, 9.2) is part of a plurality of pins and wherein said plurality of pins comprise a ground pin and a case pin.

8. Header according to one of the claims 1 to 7, wherein said cover part (5) comprises a pattern.

9. Header according to claim 8, wherein said pattern is a circuit layout using a metal or a paste.

10. Header according to one of the claims 1 to 11, wherein electronic components are positioned on the cover part (5).

11. Electronic package comprising at least a header according to one of the claims 1 to 10.

12. Electronic package according to claim 11, wherein said electronic package comprises a cap (3100) which is interconnected at least to said header (3000).

13. Electronic package according to claim 12, wherein said cap and said header is interconnected in such a way, that a hermetically sealed housing results.

14. Process for manufacturing an electronic package with the following steps:
providing at least a header according to one of the claims 1 to 13 sealing said header (3000) to a cap (3100).

15. Process according to claim 14, wherein said header is sealed to said cap by one of the following sealing techniques:
resistance welding
laser welding
press-fit welding
cold welding
phase controlled welding
capacitor discharge welding

16. Process according to one of the claims 14 to 15, wherein said electronic package is patterned with a pattern before said cap is sealed to said header.

17. Process according to claim 16, wherein said pattern comprises one of the following materials:
Tungsten
TiW.

18. Process according to one of the claims 14 to 15, wherein said electronic package is patterned with a pattern after said cap is sealed to said header.

19. Process according to claim 18, wherein said pattern comprises:
Ag
AgPt
Au
TiW

## Patentansprüche

1. Kopfstück für elektronische Gehäuse, umfassend:
- einen hohlen Kopf (1), gefüllt mit
- einem Glasmaterial, wobei das Glasmaterial wenigstens einen Stift (9.1, 9.2, 9) aufnimmt; und
- wobei der hohle Kopf (1) wenigstens aus einem hohlen Teil (3) und einem Abdeckungsteil (5) besteht; und
- wobei der hohle Teil (3) und der Abdeckungsteil (5) separate Teile sind; und
- wobei der hohle Teil (3) das Glasmaterial umgibt;
- wobei der Abdeckungsteil (5) den hohlen Teil (3) bedeckt;
- wobei der hohle Teil (3) aus einem Metall gefertigt ist;
- wobei der Abdeckungsteil (5) aus einer Keramik gefertigt ist und Löcher (13.1, 13.2) umfasst, durch die der wenigstens eine Stift (9.1, 9.2) in die obere Seite (15) des Abdeckungsteils (5) eingeführt wird;
**dadurch gekennzeichnet, dass**
- das Glasmaterial eine Glasvorform (7) ist, die in den hohlen Teil (3) eingefügt wird
und dass
- die Glasvorform (7) Löcher (11.1, 11.2) umfasst, durch die der wenigstens eine Stift (9.1, 9.2, 9) eingeführt wird, sodass kein Glasmaterial den wenigstens einen Stift (9.1, 9.2) in den Löchern (13.1, 13.2) des Abdeckungsteils (5) umgibt.

2. Kopfstück nach Anspruch 1, wobei der hohle Teil die Form einer Öse aufweist.

3. Kopfstück nach einem der Ansprüche 1 bis 2, wobei das Metall eines der folgenden Metalle oder eine Kombination davon ist:
- ein Stahl
- eine Stahllegierung
- eine Eisenlegierung
- eine Nickellegierung
- eine Eisen-Nickel-Legierung.

4. Kopfstück nach einem der Ansprüche 1 bis 3, wobei das Keramikmaterial eines der folgenden Materialien oder eine Kombination davon ist:
AlN
Al₂O₃
BeO.

5. Kopfstück nach einem der Ansprüche 1 bis 4, wobei das Kopfstück einen Thermostift (430, 530, 630) umfasst, der eines der folgenden Materialien oder eine Kombination davon umfasst:
AlN
CuW
Kovar
SiC.

6. Kopfstück nach einem der Ansprüche 1 bis 5, wobei das Glasmaterial (7) aus einem Glasmaterial besteht, das im Wesentlichen den gleichen Wärmeausdehnungskoeffizienten aufweist wie das Metall des umgebenden hohlen Teils und die Keramik des Abdeckungsteils.

7. Kopfstück nach einem der Ansprüche 1 bis 6, wobei der Stift (9.1, 9.2) Teil einer Vielzahl von Stiften ist und wobei die Vielzahl von Stiften einen Erdungsstift und einen Gehäuseanschlussstift umfasst.

8. Kopfstück nach einem der Ansprüche 1 bis 7, wobei der Abdeckungsteil (5) ein Muster umfasst.

9. Kopfstück nach Anspruch 8, wobei das Muster eine Schaltungsanordnung mithilfe eines Metalls oder einer Paste ist.

10. Kopfstück nach einem der Ansprüche 1 bis 11, wobei elektronische Bauteile auf dem Abdeckungsteil (5) positioniert sind.

11. Elektronisches Gehäuse, umfassend wenigstens ein Kopfstück nach einem der Ansprüche 1 bis 10.

12. Elektronisches Gehäuse nach Anspruch 11, wobei das elektronische Gehäuse eine Kappe (3100) umfasst, die wenigstens mit dem Kopfstück (3000) verbunden ist.

13. Elektronisches Gehäuse nach Anspruch 12, wobei die Kappe und das Kopfstück derart miteinander verbunden sind, dass daraus eine hermetisch versiegelte Einhausung resultiert.

14. Verfahren zur Herstellung eines elektronischen Gehäuses mit den folgenden Schritten:
Bereitstellen von wenigstens einem Kopfstück nach einem der Ansprüche 1 bis 13;
Siegeln des Kopfstücks (3000) an eine Kappe (3100).

15. Verfahren nach Anspruch 14, wobei das Kopfstück durch eine der folgenden Siegelungstechniken an die Kappe gesiegelt wird:
Widerstandsschweißen
Laserschweißen
Presssitzschweißen
Kaltschweißen
phasengesteuertes Schweißen
Kondensatorentladungsschweißen.

16. Verfahren nach einem der Ansprüche 14 bis 15, wobei das elektronische Gehäuse mit einem Muster gemustert wird, bevor die Kappe an das Kopfstück gesiegelt wird.

17. Verfahren nach Anspruch 16, wobei das Muster eines der folgenden Materialien umfasst:
Wolfram
TiW.

18. Verfahren nach einem der Ansprüche 14 bis 15, wobei das elektronische Gehäuse mit einem Muster gemustert wird, nachdem die Kappe an das Kopfstück gesiegelt wurde.

19. Verfahren nach Anspruch 18, wobei das Muster Folgendes umfasst:
Ag
AgPt
Au
TiW.

## Revendications

1. Embase pour boîtiers électroniques comprenant :
- une tête creuse (1) remplie
- d'un matériau de verre, dans lequel ledit matériau de verre accueille au moins une broche (9.1, 9.2, 9) et ;
- dans laquelle ladite tête creuse (1) est composée d'au moins une partie creuse (3) et d'une partie de couverture (5) ; et
- dans laquelle ladite partie creuse (3) et ladite partie de couverture (5) sont des parties séparées, et
- dans laquelle la partie creuse (3) entoure le matériau de verre
- dans laquelle la partie de couverture (5) couvre la partie creuse (3)
- dans laquelle la partie creuse (3) est constituée d'un métal,
- dans laquelle la partie de couverture (5) est constituée d'une céramique et comprend des trous (13.1, 13.2) à travers lesquels ladite au moins une broche (9.1, 9.2) est introduite dans le côté supérieur (15) de la partie de couverture (5), **caractérisée en ce que**
- ledit matériau de verre est une préforme de verre (7) qui est insérée dans ladite partie creuse (3) et **en ce que**
ladite préforme de verre (7) comprend des trous (11.1, 11.2) à travers lesquels ladite au moins une broche (9.1, 9.2, 9) est introduite de sorte qu'aucun matériau de verre n'entoure ladite au moins une broche (9.1, 9.2) dans lesdits trous (13.1, 13.2) de la partie de couverture (5).

2. Embase selon la revendication 1, dans laquelle ladite partie creuse a une forme d'oeillet.

3. Embase selon l'une des revendications 1 et 2, dans laquelle ledit métal est l'un des métaux suivants ou l'une de leur combinaison :
- un acier
- un alliage d'acier
- un alliage de fer
- un alliage de nickel
- un alliage de fer-nickel.

4. Embase selon l'une des revendications 1 à 3, dans laquelle ledit matériau céramique est l'un des matériaux suivants ou l'une de leur combinaison :
AlN
Al₂O₃
BeO.

5. Embase selon l'une des revendications 1 à 4, dans laquelle ladite embase comprend une broche thermique (430, 530, 630) comprenant l'un des matériaux suivants ou l'une de leur combinaison :
AlN
CuW
Kovar
SiC.

6. Embase selon l'une des revendications 1 à 5, dans laquelle le matériau de verre (7) consiste en un matériau de verre qui a sensiblement le même coefficient de dilatation thermique que le métal de la partie creuse environnante et la céramique de la partie de couverture.

7. Embase selon l'une des revendications 1 à 6, dans laquelle ladite broche (9.1, 9.2) fait partie d'une pluralité de broches et dans laquelle ladite pluralité de broches comprend une broche de masse et une broche de châssis.

8. Embase selon l'une des revendications 1 à 7, dans laquelle ladite partie de couverture (5) comprend un motif.

9. Embase selon la revendication 8, dans laquelle ledit motif est une configuration de circuit utilisant un métal ou une pâte.

10. Embase selon l'une des revendications 1 à 11, dans laquelle des composants électroniques sont positionnés sur la partie de couverture (5).

11. Boîtier électronique comprenant au moins une embase selon l'une des revendications 1 à 10.

12. Boîtier électronique selon la revendication 11, dans lequel ledit boîtier électronique comprend une coiffe (3100) qui est interconnectée à au moins ladite embase (3000).

13. Boîtier électronique selon la revendication 12, dans lequel ladite coiffe et ladite embase sont interconnectées de telle manière qu'il en résulte un logement hermétiquement scellé.

14. Procédé de fabrication d'un boîtier électronique comportant les étapes suivantes :
fourniture d'au moins une embase selon l'une des revendications 1 à 13
scellage de ladite embase (3000) sur une coiffe (3100).

15. Procédé selon la revendication 14, dans lequel ladite embase est scellée à ladite coiffe par l'une des techniques de scellage suivantes :
soudage par résistance
soudage au laser
soudage d'emboîtement
soudage à froid
soudage à commande de phase
soudage à décharge de condensateur.

16. Procédé selon l'une des revendications 14 à 15, dans lequel ledit boîtier électronique est formé en motif avec un motif avant que ladite coiffe soit scellée sur ladite embase.

17. Procédé selon la revendication 16, dans lequel ledit motif comprend l'un des matériaux suivants :
tungstène
TiW.

18. Procédé selon l'une des revendications 14 à 15, dans lequel ledit boîtier électronique est formé en motif avec un motif après que ladite coiffe est scellée sur ladite embase.

19. Procédé selon la revendication 18, dans lequel ledit motif comprend :
Ag
AgPt
Au
TiW.
